# EUROPEAN PATENT APPLICATION

(11) **EP 4 542 592 A1**
(43) Date of publication of application: **23.04.2025**
(21) Application number: 23838649.4
(22) Date of filing: 17.06.2023
(51) Int. Cl.: H01F 27/30

(54) **INTEGRATED INDUCTOR, CIRCUIT BOARD ASSEMBLY AND INVERTER**

(30) Priority: 13.07.2022 CN 202210821256
(71) Applicant: Huawei Digital Power Technologies Co., Ltd., Shenzhen, Guangdong 518043 (CN)
(72) Inventor: LIANG, Jinkun, Shenzhen, Guangdong 518043 (CN); ZHI, Yanjun, Shenzhen, Guangdong 518043 (CN); ZHENG, Zhou, Shenzhen, Guangdong 518043 (CN); HU, Xiaoqing, Shenzhen, Guangdong 518043 (CN); JING, Xiaming, Shenzhen, Guangdong 518043 (CN)
(74) Representative: Isarpatent
(86) International application number: PCT/CN2023/100913
(87) International publication number: WO 2024/012155

(57) **Abstract**

This application provides an integrated inductor, a circuit board assembly, and an inverter. The integrated inductor includes a first magnetic core, at least two second magnetic cores, and at least two windings. The first magnetic core includes a first surface and a second surface that are opposite to each other in a first direction, and the first magnetic core is provided with a first through hole that penetrates the first surface and the second surface. The second magnetic cores are disposed in the first direction on a side that is of the first surface and that is away from the second surface, and each second magnetic core is provided with one second through hole. The winding is wound around the first magnetic core and the second magnetic core, the windings and the first magnetic core form a common-mode inductor, and the windings and the second magnetic core form a differential-mode inductor. The second magnetic core includes a first part and a second part. Along the first direction and on a side that is of the first surface and that is opposite to the second surface, the first part is located between the winding and the first surface, and the second part is located on side that is of the winding and that is away from the first surface. The first magnetic core and the second magnetic core share a group of windings, so that a board space occupied during mounting of the integrated inductor can be reduced while working efficiency of the integrated inductor is ensured.

## Description

This application claims priority to Chinese Patent Application No. 202210821256.3, filed with the China National Intellectual Property Administration on July 13, 2022 and entitled "INTEGRATED INDUCTOR, CIRCUIT BOARD ASSEMBLY, AND INVERTER", which is incorporated herein by reference in its entirety.

### TECHNICAL FIELD

This application relates to the field of inductors, and in particular, to an integrated inductor, a circuit board assembly, and an inverter.

### BACKGROUND

With the development of modern industrial technologies, various nonlinear and time-varying power electronic apparatuses such as inverters are widely used in power systems, which has many negative effects while improving industrial production efficiency. An interference electromagnetic field in the inverter generates differential-mode currents between conducting wires or common-mode currents between conducting wires and the ground. Both of them interfere with loads and affect normal operation of the loads. For generated differential-mode interference and common-mode interference, a differential-mode inductor is usually used to suppress the differential-mode interference, and a common-mode inductor is usually used to suppress the common-mode interference.

How to design an architecture integrating a common-mode inductor and a differential-mode inductor, that is, to ensure that common-mode interference and differential-mode interference can be suppressed and that the architecture has an advantage of miniaturization, is a research direction in the industry.

### SUMMARY

This application provides an integrated inductor, a circuit board assembly, and an inverter. The integrated inductor has an advantage of miniaturization, and can ensure suppression of common-mode interference and differential-mode interference.

According to a first aspect, this application provides an integrated inductor, including a first magnetic core, at least two second magnetic cores, and at least two windings, where the first magnetic core includes a first surface and a second surface that are disposed opposite to each other in a first direction, where the first magnetic core is provided with a first through hole that penetrates the first surface and the second surface. The second magnetic cores are disposed in the first direction on a side that is of the first surface and that is away from the second surface, and each second magnetic core is provided with one second through hole. The at least two windings are disposed in a one-to-one correspondence with the second magnetic cores, where each winding passes through the first through hole and one corresponding second through hole, so that each winding is wound around the first magnetic core and one second magnetic core, the at least two windings and the first magnetic core form a common-mode inductor, and the at least two windings and the at least two second magnetic cores form a differential-mode inductor. Each second magnetic core includes a first part and a second part. Along the first direction and on a side that is of the first surface and that is opposite to the second surface, the first part is located between the winding and the first surface, and the second part is located on side that is of the winding and that is away from the first surface.

Specifically, the first part and the second part of the second magnetic core may be an integrally formed structure (for example, made of a ferrite material through integral molding), or the first part and the second part may be a split structure and are fastened as an integrated structure through adhesive assembling.

In this solution, the first magnetic core and the second magnetic core share a group of windings, the first magnetic core and the windings form the common-mode inductor, and the second magnetic core and the windings form the differential-mode inductor. In this way, the common-mode inductor and the differential-mode inductor can be integrated as a whole while working efficiency of the integrated inductor is ensured, which saves space and reduces costs. According to the integrated inductor provided in this embodiment of this application, the common-mode inductor and the differential-mode inductor share a group of windings, so that a copper loss can be reduced, and impact of the copper loss on efficiency of an inverter system can be reduced, thereby effectively improving efficiency of the integrated inductor. When the integrated inductor is assembled on a circuit board, the first direction may be perpendicular to a surface that is of the circuit board and that is used to mount the integrated inductor. In this application, the first magnetic core and the second magnetic core are disposed in a stacking manner in the first direction, which can reduce an area that is occupied by the integrated inductor on the circuit board.

In an implementation of the first aspect, each winding includes two wiring pins, and all wiring pins of the at least two windings are arranged in the first direction on a side that is of the second surface and that is opposite to the first surface. In this solution, the wiring pins are limited to being arranged in the first direction on the side that is of the second surface and that is opposite to the first surface. Because the wiring pins are configured to connect the integrated inductor to the circuit board, in this solution, positions of the wiring pins are limited, which may be specifically understood as that the wiring pins, common-mode magnetic cores, and differential-mode magnetic cores are sequentially arranged in the first direction. This solution reduces board space that is occupied by an integrated circuit on the circuit board. All the wiring pins are located on a same side of the first magnetic core. In a process of assembling the integrated inductor to the circuit board, the wiring pins can be easily securely mounted in batches, thereby improving processing efficiency in the assembly process.

In an implementation of the first aspect, vertical projections of all second through holes on the first surface are located within the first surface. When the projection of the second through hole in the first direction completely falls within the first surface, that is, when the projection of the second magnetic core in the first direction and a projection of the first magnetic core in the first direction greatly overlap, a projection area of the integrated inductor in the first direction can be reduced. In this solution, a position relationship between the second through hole and the first surface is limited, so that a vertical projection of the second through hole on the first surface does not exceed the first surface of the first magnetic core. Disposing of the second magnetic core in the integrated inductor provided in this solution does not affect a maximum radial size of the first magnetic core. This ensures a total size of the integrated inductor in a direction perpendicular to the first direction and reduces an occupied board space.

In an implementation of the first aspect, each second magnetic core includes a third surface and a fourth surface, the second through hole communicates with the third surface and the fourth surface, the first surface is planar, the third surface or the fourth surface is planar or cambered, and the third surface is perpendicular to the first surface. Because the first surface may be understood as a reference surface on which all second magnetic cores are disposed, limiting the first surface of the first magnetic core to be planar improves stability of connection between the second magnetic core and the first magnetic core, and ensures consistency of assembly positions of all the second magnetic cores. In this solution, a specific structural form of the second magnetic core is summarized. The third surface is perpendicular to the first surface, so that projections of the second magnetic core and the first magnetic core in the first direction greatly overlap, and the projection area of the integrated inductor in the first direction can be reduced. When the third surface and the fourth surface are cambered, a vertical relationship between the first surface and the third surface may be understood as follows: A generatrix of the third surface is perpendicular to the first surface, and the generatrix of the third surface may be any one of moving lines that form a cambered surface on the cambered third surface.

In an implementation of the first aspect, an air gap is provided between the first magnetic core and the second magnetic core. In this solution, a magnetic circuit formed by the first magnetic core and a magnetic circuit formed by the second magnetic core are isolated by using the air gap between the first magnetic core and the second magnetic core, so that a common-mode magnetic circuit and a differential-mode magnetic circuit are independent of each other and do not affect each other, thereby improving an overall anti-saturation capability of the integrated inductor.

In an implementation of the first aspect, a value range of the air gap is greater than or equal to 5 µm. When the air gap is within the value range, a layout of the integrated inductor can be compact, so that occupied mounting space can be reduced, and an overall anti-saturation capability of the integrated inductor can be maximized.

In an implementation of the first aspect, a first insulation layer is provided on an outer surface of the first magnetic core, and the first insulation layer forms at least a part of the air gap. In this solution, the first insulation layer on the outer surface of the first magnetic core is disposed to form at least a part of the air gap. The first insulation layer can protect the first magnetic core, and the first insulation layer is used as a magnetic circuit isolation structure between the first magnetic core and the second magnetic core. That is, the first insulation layer has dual functions. This solution helps implement miniaturization of a size of the integrated inductor while ensuring that the common-mode magnetic circuit and the differential-mode magnetic circuit are independent of each other.

In an implementation of the first aspect, a second insulation layer is provided on an outer surface of the second magnetic core, and the second insulation layer forms at least a part of the air gap. In this solution, the second insulation layer on the outer surface of the second magnetic core is disposed to form at least a part of the air gap. The second insulation layer can protect the first magnetic core, and the second insulation layer is used as a magnetic circuit isolation structure between the first magnetic core and the second magnetic core. That is, the second insulation and has dual functions. This solution helps implement miniaturization of the size of the integrated inductor while ensuring that the common-mode magnetic circuit and the differential-mode magnetic circuit are independent of each other.

In an implementation of the first aspect, there are three windings and three second magnetic cores, and a three-phase integrated inductor is limited in this solution.

In an implementation of the first aspect, there are two windings and two second magnetic cores, and a two-phase integrated inductor is limited in this solution.

In an implementation of the first aspect, the integrated inductor further includes a chassis, where the chassis is located on a side that is of the second surface and that is opposite to the first surface; and all the wiring pins of the winding are fastened to the chassis. The chassis is made of an insulation material. The chassis is configured to fasten all the wiring pins, so that the wiring pins of the integrated inductor can be easily managed and the wiring pins can be easily securely mounted (mounted on the circuit board) subsequently. In addition, the chassis can isolate functional structures (that is, the first magnetic core, the second magnetic cores, and the windings) of the integrated inductor from a mounting surface on the circuit board, so as to protect the integrated inductor.

In an implementation of the first aspect, each wiring pin passes through the chassis, and a part of the wiring pin is located on a side that is of the chassis and that is opposite to the first magnetic core. In this solution, the wiring pins are limited to pass through the chassis and be exposed on the side that is of the chassis and that is away from the first magnetic core. When the integrated circuit is assembled on the circuit board, the assembly position is on the side that is of the chassis and that is away from the first magnetic core. The wiring pins do not need to be connected in space outside a mounting region occupied by the integrated inductor on the circuit board, and the wiring pins are hidden between the chassis and the circuit board, so that occupied board space can be reduced. In addition, in a process of assembling the wiring pins, the chassis is used to isolate an assembly region from the first magnetic core. For example, when the assembly is performed through soldering, because of isolation of the chassis, a soldering temperature does not affect the first magnetic core and the windings.

In an implementation of the first aspect, the chassis includes at least two mounting parts, each mounting part is fastened to the wiring pin of one winding, and the at least two mounting parts are independent of each other, or the at least two mounting parts are connected by using a flexible connector. When the integrated inductor is fastened, if a height of a mounting surface is not uniform, a split chassis (or a chassis that is formed by connecting at least two mounting parts by using a flexible connector) may better adapt to the mounting surface whose height is not uniform, and a mounting posture of the integrated inductor may be adjusted based on a height difference. This greatly enhances adaptability of the integrated inductor to a mounting environment, and the integrated inductor may be applied in more scenarios.

In an implementation of the first aspect, the integrated inductor further includes an insulator, the insulator is disposed between adjacent windings, and a part of the insulator is located in the first through hole. In this solution, the insulator is disposed between adjacent windings, so that an electrical effect between the adjacent windings can be effectively isolated, and the integrated inductor is not damaged due to breakdown.

In an implementation of the first aspect, each winding includes an abutting part, each abutting part is in contact with the insulator, and the abutting part is elastically deformed by contacting the insulator. In this solution, a location setting between the windings is limited by limiting contact between the abutting part of each winding and the insulator and generating elastic deformation, so that a spacing between the windings is relatively short and is less than a thickness of the insulator. In this way, when the insulator is mounted between the windings, elastic deformation is caused by the abutting part. This solution helps implement a miniaturization design of the integrated circuit. Each winding abuts against the insulator, so that an internal layout of the integrated inductor is compact, and a mounting area occupied by the integrated inductor can be effectively reduced.

In an implementation of the first aspect, the insulator includes a middle column and three insulation plates connected to an outer side surface of the middle column, there are three windings, and each of the three insulation plates is located between two adjacent windings. This solution defines a specific architecture of an insulation plate. The insulator is of an integrated structure, and the insulator has a simple structure, which facilitates mass production. In addition, the integrated insulator requires simple mounting steps, which can effectively improve mounting efficiency.

In an implementation, the insulator is fastened to the chassis, and the insulator may be fastened to the chassis by using adhesive, or may be fastened to the chassis through fitting between a buckle and a slot. For example, a buckle is disposed at the bottom of the insulator, a slot is provided on the chassis, and the buckle is inserted into the slot, so that the insulator can be fastened to the chassis.

In an implementation, the insulator and the chassis are of an integrally formed structure. This solution improves stability of an overall structure of the integrated inductor.

In an implementation, a magnetic permeability of the first magnetic core of the common-mode inductor is 20000 H/m, and a magnetic permeability of the second magnetic core of the differential-mode inductor is 1000 H/m. In this solution, the magnetic permeability of the first magnetic core and the magnetic permeability of the second magnetic core are limited, to limit a specific architecture of the integrated inductor.

In an implementation, the magnetic permeability of the first magnetic core of the common-mode inductor is 7000 H/m, and the magnetic permeability of the second magnetic core of the differential-mode inductor is 125 H/m. In this solution, the magnetic permeability of the first magnetic core and the magnetic permeability of the second magnetic core are limited, to limit a specific architecture of the integrated inductor.

According to a second aspect, this application provides a circuit board assembly, including a circuit board and the integrated inductor according to the first aspect, where the integrated inductor is connected to the circuit board. The integrated inductor is mounted to the circuit board. Because the integrated inductor provided in this application has a compact structure, when the integrated inductor is mounted to the circuit board, a relatively small occupied board area is occupied in the first direction, so that mounting space is saved for another component on the circuit board, and a layout of the components on the circuit board is more proper.

According to a third aspect, this application provides a circuit board assembly, including a circuit board and the integrated inductor according to the first aspect, where the circuit board includes an inductor mounting region, a pad is disposed in an inductor mounting region, an outer profile of the integrated inductor is consistent with the inductor mounting region, and a wiring pin of the integrated inductor is soldered to the pad. The wiring pin is fastened to the pad, so that the integrated inductor is fastened to the circuit board. In addition, because a projection area of the integrated inductor in a first direction is small, an area of the inductor mounting region is small, so that mounting space is saved for another component on the circuit board, and an internal layout of the circuit board assembly is more proper.

According to a fourth aspect, this application provides an inverter, including a housing and the circuit board assembly according to the third aspect or the fourth aspect, where the housing surrounds the circuit board assembly. The circuit board assembly has a proper internal layout and a compact structure, which can effectively reduce overall space of the inverter while ensuring working efficiency of the inverter.

### BRIEF DESCRIPTION OF DRAWINGS

FIG. 1 is a diagram of a power supply system of an inverter according to an embodiment of this application;
FIG. 2 is a diagram of an assembly structure of an inverter according to an embodiment of this application;
FIG. 3 is a diagram of an assembly structure of an integrated inductor according to an embodiment of this application;
FIG. 4 is a top view of an assembly structure of an integrated inductor according to an embodiment of this application;
FIG. 5 is a diagram of an exploded structure of an integrated inductor according to an embodiment of this application;
FIG. 6 is a diagram of an assembly structure of an integrated inductor according to an embodiment of this application;
FIG. 7 is a diagram of a structure of a chassis of an integrated inductor according to an embodiment of this application;
FIG. 8 is a diagram of another structure of a chassis of an integrated inductor according to an embodiment of this application;
FIG. 9 is a diagram of a structure of a common-mode component of an integrated inductor according to an embodiment of this application;
FIG. 10 is a diagram of a structure of a differential-mode magnetic core of an integrated inductor according to an embodiment of this application;
FIG. 11 is a diagram of another structure of a differential-mode magnetic core of an integrated inductor according to an embodiment of this application;
FIG. 12 is a diagram of a structure of a winding of an integrated inductor according to an embodiment of this application;
FIG. 13 is a diagram of a structure of an insulator of an integrated inductor according to an embodiment of this application;
FIG. 14 is a diagram of a structure for fitting between a winding and an insulator according to an embodiment of this application; and
FIG. 15 is a diagram of a structure of a circuit board according to an embodiment of this application.

### DESCRIPTION OF EMBODIMENTS

### Explanation of Some Terms

Parallel: "Parallel" defined in this application is not limited to being absolutely parallel. The definition of "parallel" may be understood as being basically parallel, a case of being not absolutely parallel due to factors such as an assembly tolerance, a design tolerance, and a structural flatness is allowed. Because of the foregoing factors, a sliding fitting part and a first door plate may be not absolutely parallel to each other. However, this application also defines this case as being parallel.

Perpendicular: "Perpendicular" defined in this application is not limited to a relationship of being absolutely perpendicularly intersected (an included angle is 90 degrees), a relationship of being not absolutely perpendicularly intersected that is caused by factors such as an assembly tolerance, a design tolerance, and a structural flatness is allowed, and an error within a small angle range is allowed. For example, a relationship within an assembly error range of 80 degrees to 100 degrees may be understood as a relationship of being perpendicular.

The terms "first", "second", and the like are merely intended for a purpose of description, and shall not be understood as an indication or implication of relative importance or implicit indication of a quantity of indicated technical features. Therefore, a feature limited by "first", "second", or the like may explicitly or implicitly include one or more features.

The following provides embodiments as examples for describing the solutions of this application.

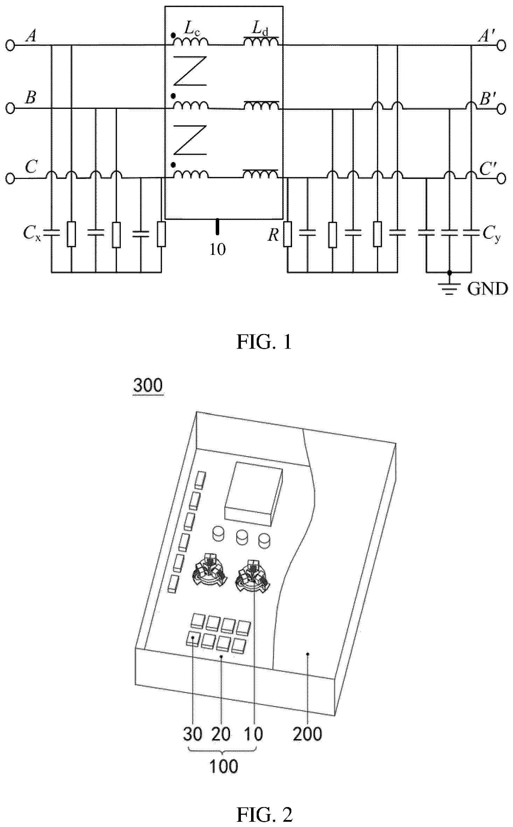

Inverters are widely used in a photovoltaic power supply scenario and a scenario in which a frequency converter is used for power control. In these scenarios, differential-mode interference and common-mode interference may adversely affect a circuit system, and a filter circuit is usually used to perform filtering on the circuit system. Common-mode signals are signals with equal amplitude and a same phase. Differential-mode signals are signals with equal amplitude and opposite phases. In a closed circuit, common-mode interference signals have equal amplitude and a same direction on two conducting wires, and are essentially caused by a voltage difference between the two live wires and a ground cable in the closed loop; and differential-mode interference signals have equal amplitude and opposite phases between two conducting wires, and are essentially caused by interference between the two live wires. As shown in FIG. 1, in a three-phase line, a terminal "A", a terminal "B", and a terminal "C" are power input terminals of a power system of and an inverter, and a terminal "A'", a terminal "B'", and a terminal "C'" are power output terminals of the power system of and the inverter. An inductor Lc is a common-mode inductor and is mainly used to suppress common-mode interference. An inductor Ld is a differential-mode inductor and is mainly used to filter and suppress differential-mode resonance.

In an implementation, the common-mode inductor Lc and the differential-mode inductor Ld of the inverter are independent of each other, and are separately mounted as two independent inductance elements.

FIG. 1 is a diagram of a power system of an inverter according to an embodiment of this application. FIG. 2 is a diagram of a structure of an inverter 300 according to an embodiment of this application. Refer to FIG. 1 and FIG. 2. Based on requirements for improving power density and reducing costs, the inverter 300 provided in an implementation of this application integrates a common-mode inductor Lc and a differential-mode inductor Ld into an integrated inductor 10, to reduce a volume of the common-mode inductor Lc and a volume of the differential-mode inductor Ld, so as to reduce an occupied board space and reduce costs.

As shown in FIG. 2, this application provides an inverter 300. The inverter 300 may include a circuit board assembly 100 and a housing 200. The housing 200 surrounds an outer side of the circuit board assembly 100 to protect the circuit board assembly 100. The circuit board assembly 100 may include other electronic components such as an integrated inductor 10, a circuit board 20, and a control chip 30. The integrated inductor 10 and the control chip 30 are fastened to the circuit board 20.

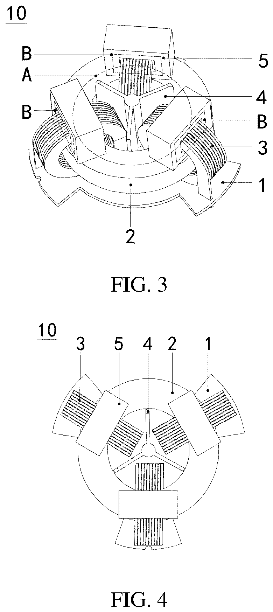

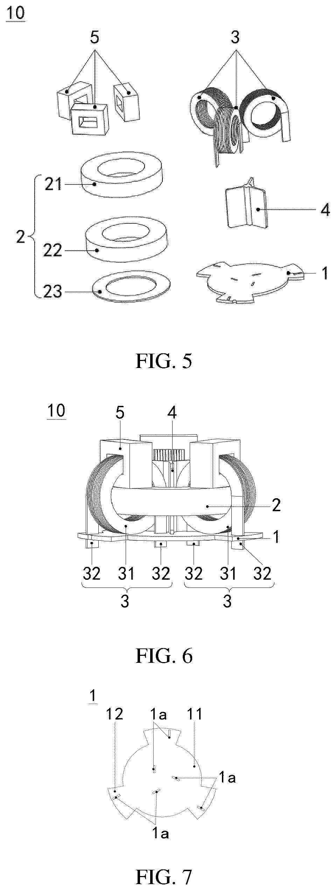

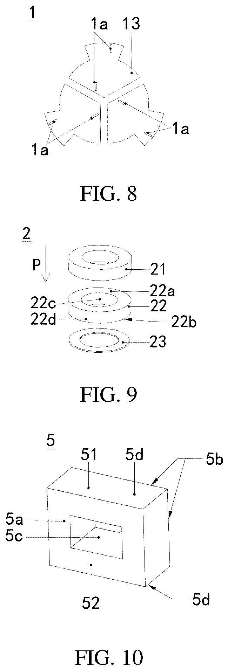

FIG. 3, FIG. 4, FIG. 5, and FIG. 6 are diagrams of a structure of an integrated inductor 10 according to an embodiment of this application. The integrated inductor 10 may include a chassis 1, a common-mode component 2, windings 3, differential-mode magnetic cores 5, and an insulator 4. The common-mode component 2, the windings 3, and the differential-mode magnetic cores 5 are functional components of the integrated inductor 10, and are configured to generate common-mode inductance for suppressing common-mode interference and generate differential-mode inductance for suppressing resonance and differential-mode interference. The chassis 1 is a structure for assembling the foregoing functional components of the integrated inductor 10. The following describes a specific architecture of the chassis 1 with reference to FIG. 7 and FIG. 8.

As shown in FIG. 7, the chassis 1 may be of a plate structure, and the chassis 1 may include a base plate 11 and protruding portions 12. In an implementation, the chassis 1 may be of an integrated structure, as shown in FIG. 7, that is, the base plate 11 and the protruding portions 12 are connected as a whole. The base plate 11 is approximately a circular plate, and the protruding portion 12 is approximately a fan-shaped plate structure. The protruding portions 12 are evenly distributed at an edge of the base plate 11, and are fastened to the base plate 11, for example, the protruding portions 12 and the base plate 11 may be connected as a whole. A quantity of protruding portions 12 matches a quantity of windings 3. For example, there may be three protruding portions. Three groups of mounting holes 1a are provided on the protruding portions 12 and the base plate 11, and are configured to fasten the windings 3 to the chassis 1 (which is further described below). A quantity of mounting holes 1a also matches the quantity of windings 3.

In the foregoing implementation, the chassis 1 is of an integrated structure. In another implementation, the chassis 1 may be of a split structure. As shown in FIG. 8, the chassis 1 may include a plurality of mounting parts 13, and a quantity of mounting parts 13 may be determined based on the quantity of windings 3. Each mounting part 13 is provided with a group of mounting holes 1a, which are configured to securely mount the winding 3 to the chassis 1. The plurality of mounting parts 13 are independent of each other, or at least two mounting parts are connected by using a flexible connector. A manner in which each mounting part 13 is fastened to the winding 3 is approximately the same as a manner in which the chassis 1 of the integrated structure is connected to the winding 3 (which is described below). An advantage of disposing the chassis 1 as a split structure is that, when the integrated inductor 10 is fastened to the circuit board 20, if mounting surfaces of the circuit board 20 have different heights, the split chassis 1 can adapt to the mounting surfaces with different heights to some extent, to adjust a mounting posture of the integrated inductor 10 based on height differences, so that adaptability of the integrated inductor 10 to a mounting environment is greatly enhanced, and the integrated inductor 10 may be used in more scenarios. In addition, the chassis 1 can isolate functional structures (that is, the common-mode component 2, the differential-mode magnetic cores 5, and the windings 3) of the integrated inductor 10 from a mounting surface on the circuit board 20, to protect the integrated inductor 10.

The following describes a structure of the common-mode component 2 and a position relationship between the common-mode component 2 and the chassis 1.

As shown in FIG. 9, the common-mode component 2 may include a common-mode magnetic core 22, an upper housing 21, and a lower housing 23. The common-mode magnetic core 22 may also be referred to as a first magnetic core, and a housing formed by the upper housing 21 and the lower housing 23 may be referred to as a first insulation layer. It may be understood that the first insulation layer is disposed on an outer side of the first magnetic core. There may be a gap between the first insulation layer and an outer surface of the first magnetic core, or the first insulation layer and the outer surface of the first magnetic core may be in contact with each other.

As shown in FIG. 9, the common-mode magnetic core 22 may be of a circular ring structure. The common-mode magnetic core 22 has a first surface 22a and a second surface 22b that are opposite to each other, and both the first surface 22a and the second surface 22b may be approximately planar. Both the first surface 22a and the second surface 22b are parts of an outer surface 22d of the common-mode magnetic core 22. The common-mode magnetic core 22 is provided with a first through hole 22c, the first through hole 22c penetrates both the first surface 22a and the second surface 22b, and an extension direction of the first through hole 22c is a first direction. Refer to FIG. 9. An extension direction of an arrow P is the first direction. The outer surface 22d of the common-mode magnetic core 22 may be understood as a surface that is of the common-mode magnetic core 22 and that is opposite to a hole wall of the first through hole 22c. The first direction is approximately perpendicular to the first surface 22a and the second surface 22b. In this embodiment of this application, the common-mode magnetic core 22 is of a circular ring structure. In another embodiment, the common-mode magnetic core 22 is not limited to being of the circular ring structure, and may also be of another polygonal ring structure. In this embodiment of this application, the common-mode magnetic core 22 may be made of a magnetic material such as an amorphous strip, a nanocrystalline strip, or a ferrite.

As shown in FIG. 9, the upper housing 21 is of an approximately annular groove structure with a through hole. The lower housing 23 is of an approximately annular cover plate structure with a through hole. Both the upper housing 21 and the lower housing 23 may be made of insulation materials.

As shown in FIG. 9, the upper housing 21 and the lower housing 23 can form accommodating space through surrounding to accommodate the common-mode magnetic core 22, so that the common-mode magnetic core 22 is surrounded by a housing made of an insulation material. The through hole of the upper housing 21 communicates with the through hole of the lower housing 23, to expose the first through hole 22c.

The chassis 1 is located on a side that is of the common-mode component 2 and on which the lower housing 23 is disposed, and there is a spacing between the chassis 1 and the common-mode component 2.

In this embodiment of this application, the outer surface 22d of the common-mode magnetic core 22 is covered by the insulation material through surrounding of the upper housing 21 and the lower housing 23. In another embodiment, the isolated upper and lower housings may not be disposed, but the surface of the common-mode magnetic core 22 is sprayed with an insulation layer, so that the outer surface 22d of the common-mode magnetic core 22 is covered by the insulation material. The outer surface 22d of the common-mode magnetic core 22 is covered by the insulation material, so that when the winding 3 is wound around the common-mode magnetic core 22, the integrated inductor 10 is not damaged due to breakdown between the winding 3 and the common-mode magnetic core 22 under an action of an overvoltage.

The following describes a structure of the differential-mode magnetic core 5 and a position relationship between the differential-mode magnetic core 5 and the common-mode component 2.

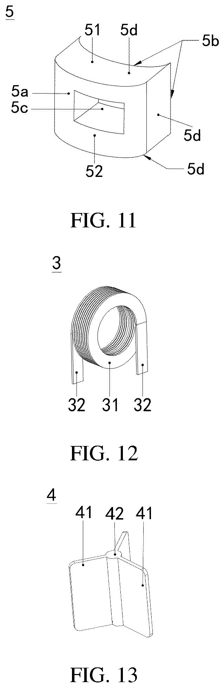

The differential-mode magnetic core 5 may also be referred to as a second magnetic core. As shown in FIG. 10, the differential-mode magnetic core 5 may be of a rectangular ring structure. The differential-mode magnetic core 5 includes a first part 51 and a second part 52. The differential-mode magnetic core 5 has a second through hole 5c, and a shape of the second through hole 5c may be designed based on a requirement. The first part 51 and the second part 52 are respectively located on both sides of the second through hole 5c. The differential-mode magnetic core 5 has a third surface 5a and a fourth surface 5b that are opposite to each other. Both the third surface 5a and the fourth surface 5b are parts of an outer surface 5d of the differential-mode magnetic core 5. The outer surface 5d of the differential-mode magnetic core 5 may be understood as a surface that is of the differential-mode magnetic core 5 and that is opposite to an inner wall of the second through hole 5c. In a direction shown in FIG. 10, the third surface 5a is a surface close to a paper surface, and the fourth surface 5b is a surface that is of the second through hole 5c and that is opposite to the third surface 5a. As shown in FIG. 10 and FIG. 11, both or either of the third surface 5a and the fourth surface 5b may be planar or cambered, and the second through hole 5c penetrates both the third surface 5a and the fourth surface 5b. In this embodiment of this application, no insulation layer is disposed on the outer surface 5d of the differential-mode magnetic core 5. In another embodiment, a second insulation layer may be disposed on the differential-mode magnetic core 5, and the second insulation layer may be an insulation layer sprayed on the outer surface 5d of the differential-mode magnetic core 5 or an insulation housing surrounding the outer surface 5d of the differential-mode magnetic core 5. The second insulation layer is configured to prevent breakdown between the differential-mode magnetic core 5 and another element of the integrated inductor 10, to prevent an internal element of the integrated inductor 10 from being damaged. It may be understood that the second insulation layer is located on an outer side of the second magnetic core (the differential-mode magnetic core), and there may be a gap between the second insulation layer and an outer surface of the second magnetic core, or the second insulation layer may be in contact with the outer surface of the second magnetic core.

In this embodiment of this application, the differential-mode magnetic core 5 is not limited to being of a rectangular ring structure, and may also be of another polygonal ring structure. In an implementation, the differential-mode magnetic core 5 is of a split structure, for example, may be formed by combining two parts, so that a manner of assembling the differential-mode magnetic core 5 is simple and convenient, and mounting efficiency can be improved in a process of assembling the integrated inductor 10. In another implementation, the differential-mode magnetic core 5 may be of an integrated structure. A processing manner of the differential-mode magnetic core 5 of the integrated structure is simple, and production efficiency can be improved in a production process of the differential-mode magnetic core 5. In this embodiment of this application, the differential-mode magnetic core 5 may be made of a material such as an amorphous strip, a nanocrystalline strip, a ferrite, silicon steel, a ferro-silicon magnetic powder core, a ferro-silicon aluminum magnetic powder core, a ferro-nickel magnetic powder core, a ferro-nickel-molybdenum magnetic powder core, or an iron powder core.

As shown in FIG. 3 and FIG. 9, in an implementation, the integrated inductor 10 is a three-phase integrated inductor; and there may be three differential-mode magnetic cores 5, the differential-mode magnetic cores 5 are located on a side that is of the common-mode component 2 and on which the first surface 22a is disposed, and the three differential-mode magnetic cores 5 are evenly distributed as three phases on the common-mode component 2.

In an implementation, along the first direction, the differential-mode magnetic core 5 and the common-mode component 2 are disposed in a stacking manner. As shown in FIG. 3, FIG. 9, and FIG. 10, the first part 51 of the differential-mode magnetic core 5 is located on a side that is of the second through hole 5c and that is close to the first surface 22a, and the second part 52 is located on a side that is of the second through hole 5c and that is away from the first surface 22a (that is, the first part 51, the second through hole 5c, and the second part 52 are sequentially distributed in the first direction). The third surface 5a may face an outer side of the common-mode component 2, and the fourth surface 5b may face the first through hole 22c of the common-mode component 2. At least a part of a projection of the second through hole 5c in the first direction falls within the first surface 22a. For example, the projection of the second through hole 5c in the first direction may completely fall within the first surface 22a. When the third surface 5a and the fourth surface 5b are planar, both the third surface 5a and the fourth surface 5b are approximately perpendicular to the first surface 22a. As shown in FIG. 3, FIG. 9, and FIG. 11, when the third surface 5a and the fourth surface 5b are cambered surfaces, a generatrix of the third surface 5a and a generatrix of the fourth surface 5b are approximately perpendicular to the first surface 22a, and the generatrix of the third surface 5a may be any one of moving lines that form a cambered surface on the cambered third surface 5a.

A vertical projection of the second through hole 5c on the first surface 22a does not exceed the first surface 22a of the common-mode magnetic core 22, that is, disposing the differential-mode magnetic core 5 does not affect a maximum radial size of the common-mode magnetic core 22. This ensures a total size of the integrated inductor 10 in the first direction, and reduces an occupied board space. In addition, the first surface 22a is planar. This can effectively improve stability of connection between the differential-mode magnetic core 5 and the common-mode component 2, and ensures consistency of mounting positions of the differential-mode magnetic core 5 and the common-mode component 2.

In an implementation, there is a spacing between the differential-mode magnetic cores 5 in this embodiment of this application. For example, for a three-phase integrated inductor, the three-phase integrated inductor has three differential-mode magnetic cores 5, and the three differential-mode magnetic cores 5 are independent of each other and are separately assembled to the common-mode component 2. In this way, a spacing is formed between adjacent differential-mode magnetic cores 5. This solution facilitates assembly, has higher flexibility in an assembly process, and improves assembly efficiency. In addition, a simple single-phase magnetic core may be selected for each differential-mode magnetic core 5, and there is no need to make three single-phase magnetic cores into an integrated structure. This improves production efficiency and reduces costs.

There is an air gap between the differential-mode magnetic core 5 and the common-mode magnetic core 22, and in the first direction, a size of the air gap is greater than or equal to 5 µm. The air gap means isolation between the differential-mode magnetic core 5 and the common-mode magnetic core 22, and the isolation is not limited to isolation performed by using an insulation medium, or may be air isolation. It may be understood that the air gap may include an insulation medium structure of an entity, or may be an interval like a gap (or a pore). In this embodiment of this application, a first insulation layer (for example, the first insulation layer may be a housing used to wrap the common-mode magnetic core 22) between the differential-mode magnetic core 5 and the common-mode magnetic core 22 forms an air gap. In another implementation, a second insulation layer (for example, the second insulation layer may be a housing used to wrap the outer surface 5d of the differential-mode magnetic core 5) may be disposed for the differential-mode magnetic core 5 to form an air gap. Alternatively, a size requirement of the air gap may be met through aerial mounting or by adding a filler. In another implementation, the foregoing implementations may be randomly combined to form the air gap.

The foregoing mainly describes the differential-mode magnetic core 5 and the common-mode component 2 of the integrated inductor 10. The following elaborates on a structure of the winding 3 and fitting between the winding 3 and both the differential-mode magnetic core 5 and the common-mode component 2 during assembly.

In this embodiment of this application, the winding 3 is formed through surrounding of a wire that is covered by an insulation layer, for example, the wire may be an enameled wire or a film-covered wire. As shown in FIG. 3 and FIG. 12, the winding 3 includes a coil body 31 and a wiring pin 32, which are connected to each other. The coil body 31 has a through hole enclosed by coils. All windings 3 have a same quantity of coil turns, and all the windings 3 have a same winding direction. A quantity of windings 3 is set to be in correspondence with a quantity of differential-mode magnetic cores 5, so that the windings 3 are in a one-to-one correspondence with the differential-mode magnetic cores 5. There are at least two windings 3. For example, there may be three windings 3. In an implementation, there may be two wiring pins 32, which are respectively located on both sides of the coil body 31 and are approximately tangent to the coil body 31. In another implementation, the wiring pins 32 may be located on a same side of the coil body 31. When different distribution manners of the wiring pins 32 on the coil body 31 are used, mounting areas occupied by the integrated inductor 10 on the circuit board 20 are different. Therefore, positions of the wiring pins 32 may be designed based on a requirement.

As shown in FIG. 3, FIG. 6, FIG. 9, and FIG. 10, the coil body 31 of each winding 3 fits with the first through hole 22c of the common-mode component 2 and the second through hole 5c of the differential-mode magnetic core 5. To be specific, the coil body 31 of each winding 3 passes through both the first through hole 22c and the second through hole 5c of the differential-mode magnetic core 5, so that each winding 3 is wound around the common-mode magnetic core 22 and one differential-mode magnetic core 5. A through hole of each coil body 31 accommodates a part of the common-mode component 2 and a first part of the differential-mode magnetic core 5, so that the first part 51 is located between the coil body 31 and the first surface 22a, and the second part 52 is located on a side that is of the coil body 31 and that is away from the first surface 22a. The wiring pins 32 of the winding 3 are all located, in the first direction, on a side that is of the second surface 22b and that is away from the first surface 22a. The three windings 3 may be evenly distributed on the common-mode component 2, and spacings between every two windings 3 are approximately equal.

As shown in FIG. 6, FIG. 7, and FIG. 9, the windings 3 are fastened to the chassis 1. Each winding 3 fits with a group of mounting holes 1a. In an implementation, one wiring pin 32 of the winding 3 extends into the first through hole 22c and passes through the mounting hole 1a on the base plate, and the other wiring pin 32 is located outside the common-mode component 2 and passes through the mounting hole 1a on the protruding portion 12. The common-mode magnetic core 22 is located on another side that is of the chassis 1 and on which the wiring pin 32 is exposed, and the second surface 22b faces the chassis 1 in the first direction. The wiring pins 32 are limited to being arranged in the first direction on the side that is of the second surface 22b and that is opposite to the first surface 22a. Because the wiring pins 32 are configured to connect the integrated inductor 10 to the circuit board 20, positions of the wiring pins 32 are limited, so that the wiring pins 32, the common-mode magnetic core 22, and the differential-mode magnetic core 5 are sequentially arranged in the first direction. This reduces board space that is occupied by the integrated inductor 10 on the circuit board 20. All the wiring pins 32 are located on a same side of the common-mode magnetic core 22. In a process of assembling the integrated inductor 10 on the circuit board 20, the wiring pins 32 are assembled on a side that is of the chassis 1 and that is away from the common-mode component 2, and no wiring pin 32 needs to be connected in space outside a mounting region occupied by the integrated inductor 10 on the circuit board 20, and the wiring pins 32 are hidden between the chassis 1 and the circuit board 20, so that occupied board space can be reduced. In addition, in a process of assembling the wiring pins 32, the chassis 1 is used to isolate an assembly region from the common-mode component 2. For example, when the wiring pins 32 are assembled through soldering, a soldering temperature does not affect the common-mode component 2 and the windings 3 due to isolation of the chassis 1.

The following describes a composition solution of magnetic circuits of the integrated inductor 10.

As shown in FIG. 3 and FIG. 9, because the common-mode magnetic core 22 is a closed ring magnetic core, the common-mode magnetic core 22 forms a closed common-mode magnetic circuit A. A common-mode inductor is formed between the common-mode magnetic core 22 and each winding 3 to suppress common-mode interference. Each differential-mode magnetic core 5 forms a closed differential-mode magnetic circuit B, and each differential-mode magnetic core 5 forms a differential-mode inductor with a winding 3 surrounding the differential-mode magnetic core 5 to suppress a differential-mode current. In addition, because there is an air gap between the differential-mode magnetic core 5 and the common-mode magnetic core 22, the air gap can ensure that the differential-mode magnetic circuit B and the common-mode magnetic circuit A are independent of each other and do not interfere with or affect each other.

The common-mode magnetic core 22 may be made of a magnetic material with a magnetic permeability of 2000 H/m to 100000 H/m, and the differential-mode magnetic core 5 may be made of a magnetic material with a magnetic permeability of 26 H/m to 5000 H/m.

In an implementation, the common-mode magnetic core 22 may be obtained by winding a nanocrystalline strip with a magnetic permeability of 20000 H/m, and the differential-mode magnetic core 5 may be made of an amorphous strip with a magnetic permeability of 1000 H/m, so that an amount of common-mode inductance is 202 microhenries, and an amount of differential-mode inductance is 12 microhenries.

In another implementation, the common-mode magnetic core 22 is made of a ferrite with a magnetic permeability of 7000 H/m, and the differential-mode magnetic core 5 is made of a ferro-silicon magnetic powder core with a magnetic permeability of 125 H/m, so that an amount of the common-mode inductance is 180 microhenries, and an amount of the differential-mode inductance is 14 microhenries.

By way of example, and not limitation, an amount of common-mode inductance formed between the winding 3 and the common-mode magnetic core 22 may be adjusted by adjusting a quantity of turns of any winding 3, or by adjusting an area of a cross section of the common-mode magnetic core 22.

In the foregoing example implementation, the common-mode magnetic core 22 and each differential-mode magnetic core 5 are of a closed ring structure. This is because when the common-mode magnetic core 22 or the differential-mode magnetic core 5 is a magnetic core of a closed ring structure, utilization of winding space of the winding 3 on the common-mode magnetic core 22 or the differential-mode magnetic core 5 can be effectively improved. Therefore, that both the common-mode magnetic core 22 and the differential-mode magnetic core 5 are of a closed ring structure is merely an example. Actually, magnetic core structures of the common-mode magnetic core 22 and the differential-mode magnetic core 5 may be designed as another solution based on a requirement. For example, the common-mode magnetic core 22 or the differential-mode magnetic cores 5 are disposed to be of an unclosed ring structure.

In an implementation, an insulator 4 is disposed in the integrated inductor, and the insulator is configured to isolate and protect adjacent windings 3.

As shown in FIG. 13, the insulator 4 may include at least two insulation plates 41, and a quantity of insulation plates 41 corresponds to a quantity of windings 3, for example, there may be three insulation plates 41. The insulation plate 41 may be of a rectangular plate structure, made of an insulation material, and configured to be disposed between adjacent windings 3 to isolate and protect the windings 3.

In this embodiment of this application, the insulator 4 may be an integrated insulator 4. As shown in FIG. 13, the integrated insulator 4 may include insulation plates 41 and a middle column 42. Three insulation plates 41 surround an outer side surface of the middle column 42, and are fastened to the middle column 42 along an axis direction of the middle column 42, and an included angle that is not 0 degrees is formed between two adjacent insulation plates 41. For example, the three insulation plates 41 of the insulator 4 are evenly distributed on the middle column 42, so that the included angle between every two adjacent insulation plates 41 is approximately 120 degrees. The integrated insulator 4 is easy to mount, and the integrated inductors 10 can be mounted in batches. This improves mounting efficiency.

In another implementation, the insulator 4 may be of a split structure, the insulator 4 includes only three insulation plates 41, and the three insulation plates 41 may not be connected to each other or may be connected to each other by using a flexible connector. The split insulator 4 allows for a flexible adjustment of a mounting position of the insulation plate 41 according to different scenarios. Therefore, the split insulator 4 has strong adaptability to an environment, and can cope with variable mounting scenarios.

As shown in FIG. 3 and FIG. 13, the insulator 4 is disposed between the three windings 3 and is fastened to the chassis 1. For example, the insulator 4 may be fastened to the chassis 1 by using adhesive, or may be fastened to the chassis 1 through fitting between a buckle and a slot. For example, a buckle is disposed at the bottom of the insulator 4, a slot is provided on the chassis 1, and the buckle is inserted into the slot, so that the insulator 4 may be fastened to the chassis 1. In another implementation, the insulator 4 and the chassis 1 are of an integrally formed structure. This improves stability of the overall structure of the integrated inductor 10.

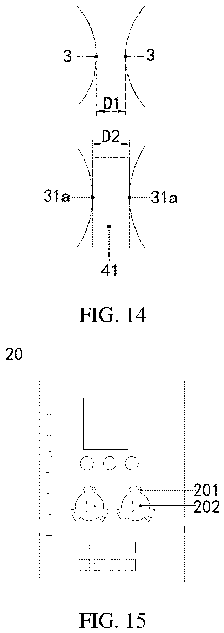

Each insulation plate 41 of the insulator 4 is located between two adjacent windings 3 to separate the two adjacent windings 3 from each other, so that breakdown between the adjacent windings 3 can be prevented in a case of current overload. In an implementation, there may be a gap between the insulation plate 41 and the windings 3 on both sides of the insulation plate 41. In another implementation, the windings 3 on both sides of the insulation plate 41 may abut against the insulation plate 41. As shown in FIG. 14, an upper half part of FIG. 14 represents a scenario in which no insulation plate 41 is disposed between the windings 3, and a spacing between the windings 3 is D1. A lower half part of FIG. 14 represents a scenario in which an insulation plate 41 is disposed between windings 3. In this case, the windings 3 on both sides of the insulation plate 41 abut against the insulation plate 41, and a part that is of the winding 3 and that abuts against the insulation plate 41 may be referred to as an abutting part 31a. A spacing between the windings 3 is D2, and it is obtained through comparison that a width of D2 is greater than a width of D1, that is, elastic deformation occurs when the abutting part 31a abuts against the insulation plate 41. Therefore, a layout between the winding 3 and the insulation plate 41 can be more compact, thereby reducing an area that is occupied by the integrated inductor 10 on the circuit board 20 in the first direction.

With reference to FIG. 2 and FIG. 15, an inductor mounting region 201 is disposed on the circuit board 20, and a pad 202 is disposed in the inductor mounting region 201. The inductor mounting region 201 is used to position and mount the integrated inductor 10, and a contour of the inductor mounting region 201 is basically the same as a projection of an outer contour of the integrated inductor 10 in the first direction. Therefore, an area of the inductor mounting region 201 is an area occupied by the integrated inductor 10 on the circuit board 20. Soldering holes on the pad 202 correspond to the wiring pins 32 of the winding 3, so that the wiring pins 32 are soldered to the pad 202. A position distribution of the pad 202 in the inductor mounting region 201 depends on a position distribution of the wiring pin 32. The position distribution of the pad 202 may be designed based on a requirement, and no excessive setting is made herein.

However, in the integrated inductor 10 in this application, the differential-mode magnetic core 5 and the common-mode magnetic core 22 are disposed in a stacking manner in the first direction, and a projection of the differential-mode magnetic core 5 in the first direction and a projection of the common-mode magnetic core 22 in the first direction greatly overlap. Because the first direction is perpendicular to the circuit board 20, utilization of a board space (that is, an area of the inductor mounting region 201) that is occupied by the integrated inductor 10 in this application on the circuit board 20 is greatly improved. Compared with another embodiment in which the differential-mode magnetic core and the common-mode magnetic core are separately mounted, in this application, the integrated inductor 10 can reduce a board space occupied on the circuit board 20 and has a higher power density.

The differential-mode magnetic core 5 and the common-mode magnetic core 22 share a three-phase winding 3. This reduces usage of the windings 3 while ensuring that a differential-mode current and the common-mode current can be suppressed, thereby effectively reducing a copper loss can be effectively reduced, reducing impact of the copper loss on system efficiency of the inverter 300, and effectively improving efficiency of the integrated inductor 10.

The differential-mode magnetic circuit B and the common-mode magnetic circuit A in this application are independent of each other. A magnetic flux of the differential-mode magnetic core 5 and a magnetic flux of the common-mode magnetic core 22 are independent of each other, so that the integrated inductor 10 can withstand a higher current and has an excellent anti-magnetic saturation capability.

In this application, the integrated inductor 10 is disposed in a stacking manner, and the projections of the differential-mode magnetic core 5 and the common-mode magnetic core 22 in the first direction greatly overlap. Therefore, when the integrated inductor 10 and the circuit board 20 are mounted, an area of the inductor mounting region 201 can be greatly reduced, and mounting space can be saved for another component on the circuit board 20, thereby reducing a volume of the circuit board assembly 100.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An integrated inductor, comprising:
a first magnetic core, comprising a first surface and a second surface that are disposed opposite to each other in a first direction, wherein the first magnetic core is provided with a first through hole that penetrates the first surface and the second surface;
at least two second magnetic cores, disposed in the first direction on a side that is of the first surface and that is away from the second surface, wherein each second magnetic core is provided with one second through hole; and
at least two windings, disposed in a one-to-one correspondence with the second magnetic cores, wherein each winding passes through the first through hole and one corresponding second through hole, so that each winding is wound around the first magnetic core and one second magnetic core, the at least two windings and the first magnetic core form a common-mode inductor, and the at least two windings and the at least two second magnetic cores form a differential-mode inductor, wherein
each second magnetic core comprises a first part and a second part that are distributed along the first direction on two opposite sides of the second through hole, the first part is located between the winding and the first surface, and the second part is located on a side that is of the winding and that is away from the first surface.

2. The integrated inductor according to claim 1, wherein
each winding comprises two wiring pins, and all the wiring pins of the at least two windings are arranged in the first direction on a side that is of the second surface and that is opposite to the first surface.

3. The integrated inductor according to claim 1 or 2, wherein
along the first direction, vertical projections of all the second through holes on the first surface are located within the first surface.

4. The integrated inductor according to any one of claims 1 to 3, wherein
each second magnetic core comprises a third surface and a fourth surface, the second through hole communicates with the third surface and the fourth surface, the first surface is planar, the third surface or the fourth surface is planar or cambered, and the third surface is perpendicular to the first surface.

5. The integrated inductor according to any one of claims 1 to 4, wherein
an air gap is provided between the first magnetic core and the second magnetic core.

6. The integrated inductor according to claim 5, wherein
a value range of the air gap is greater than or equal to 5 µm.

7. The integrated inductor according to claim 5 or 6, wherein
an outer surface of the first magnetic core is provided with a first insulation layer, and the first insulation layer forms at least a part of the air gap.

8. The integrated inductor according to any one of claims 5 to 7, wherein
an outer surface of the second magnetic core is provided with a second insulation layer, and the second insulation layer forms at least a part of the air gap.

9. The integrated inductor according to claim 2, wherein
the integrated inductor further comprises a chassis, and the chassis is located on the side that is of the second surface and that is opposite to the first surface; and all the wiring pins of the windings are fastened to the chassis.

10. The integrated inductor according to claim 9, wherein
each wiring pin passes through the chassis, and a part of the wiring pin is located on a side that is of the chassis and that is opposite to the first magnetic core.

11. The integrated inductor according to claim 9 or 10, wherein
the chassis comprises at least two mounting parts, each mounting part is fastened to the wiring pins of one winding, and the at least two mounting parts are independent of each other, or the at least two mounting parts are connected by using a flexible connector.

12. The integrated inductor according to any one of claims 1 to 11, wherein
the integrated inductor further comprises an insulator, the insulator is disposed between adjacent windings, and a part of the insulator is located in the first through hole.

13. The integrated inductor according to claim 12, wherein
each winding comprises an abutting part, each abutting part is in contact with the insulator, and the abutting part is elastically deformed by contacting the insulator.

14. The integrated inductor according to claim 12 or 13, wherein
the insulator comprises a middle column and three insulation plates connected to an outer side surface of the middle column, there are three windings, and each of the three insulation plates is located between two adjacent windings.

15. The integrated inductor according to any one of claims 1 to 14, wherein
there are three windings and three second magnetic cores; or there are two windings and two second magnetic cores.

16. A circuit board assembly, wherein
the circuit board assembly comprises a circuit board and the integrated inductor according to any one of claims 1 to 15, and the integrated inductor is connected to the circuit board.

17. A circuit board assembly, wherein
the circuit board assembly comprises a circuit board and the integrated inductor according to any one of claims 1 to 11, the circuit board comprises an inductor mounting region, a pad is disposed in the inductor mounting region, and the integrated inductor is soldered to the pad through a wiring pin.

18. An inverter, wherein
the inverter comprises a housing and the circuit board assembly according to claim 16 or 17, and the housing surrounds the circuit board assembly.
